(19) **Europäisches Patentamt**
**European Patent Office**
**Office européen des brevets**

(11) **EP 2 228 805 A1**

(12) **EUROPEAN PATENT APPLICATION**
published in accordance with Art. 153(4) EPC

(43) Date of publication:
**15.09.2010 Bulletin 2010/37**

(51) Int Cl.:
*H01B 5/14* (2006.01)          *C23C 14/08* (2006.01)
*C23C 14/34* (2006.01)          *H01B 13/00* (2006.01)

(21) Application number: **08840743.2**

(22) Date of filing: **10.10.2008**

(86) International application number:
**PCT/JP2008/068460**

(87) International publication number:
**WO 2009/051075 (23.04.2009 Gazette 2009/17)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **15.10.2007   JP 2007268343**

(71) Applicants:
• **TOKAI UNIVERSITY EDUCATIONAL SYSTEM**
  **Shibuya-ku**
  **Tokyo 1510063 (JP)**
• **Aisekku Nano Tyubu Co., Ltd.**
  **Kanagawa 236-0016 (JP)**

(72) Inventors:
• **KUJI, Toshiro**
  **Numazu-shi**
  **Shizuoka 410-0395 (JP)**

• **CHIBA, Masafumi**
  **Numazu-shi**
  **Shizuoka 410-0395 (JP)**
• **HONJO, Takamitsu**
  **Numazu-shi**
  **Shizuoka 410-0395 (JP)**
• **KOTODA, Koichiro**
  **Shizuoka-shi,**
  **Shizuoka 4200881 (JP)**

(74) Representative: **Hoffmann, Benjamin**
  **Dehns**
  **St. Bride's House**
  **10 Salisbury Square**
  **London EC4Y 8JD (GB)**

(54) **TRANSPARENT CONDUCIVE FILM AND METHOD FOR PRODUCING THE SAME**

(57)    A transparent conductive film of the present invention is a film containing magnesium, at least one element (A) selected from the group consisting of carbon, silicon and boron, oxygen, and hydrogen. For example, this transparent conductive film may be manufactured by forming a film containing magnesium and an element (A) on a substrate and holding the film in an atmosphere containing water, which forming uses a target containing magnesium and a target containing the element (A) being at least one selected from the group consisting of carbon, silicon and boron.

Fig 1
(a — 1)          (a — 2)
(a — 3)          (a — 4)

EP 2 228 805 A1

**Description**

Technical Field

The present invention relates to a transparent conductive film and a method for manufacturing the same, and more particularly relates to a transparent conductive filmo using no indium which is used for a conventional main transparent conductive film and a method for manufacturing the transparent conductive film.

Background Art

A transparent conductive film is a film having both a visible light transmission property and an electrical conductivity.

Since having a low resistivity and a high transmittance to visible light, the transparent conductive film has been widely used as a transparent electrode of a solar cell, a flat panel display, represented by a liquid crystal display, or the like. In addition, a transparent electrical conductive film composed of a resin film substrate and this transparent conductive film formed on a surface thereof is used for an electrode of a transparent touch panel, an EL (electroluminescence) flat lamp, or the like.

As the transparent conductive film, although many materials have been studied, a major transparent conductive film which is practically used at the moment is an ITO (Indium Tin Oxide) thin film primarily composed of indium oxide and tin oxide.

However, in recent years, concomitant with an increase in shipping volume of flat panel displays and the like, which are main application of the ITO thin film, the demand therefor has also increased, and in addition, since indium which is a raw material is a rare metal (Clarke number: 0.00001), the price thereof has increased, so that a resource depletion problem has been becoming serious.

Accordingly, attention has been increasingly paid to a transparent conductive film which uses no indium (ITO alternative material). As a representative ITO alternative material, a zinc oxide (ZnO)-based transparent conductive film has been known, and in researches performed in the past on a transparent conductive film as an ITO alternative material, in most cases, ZnO was used as a primary component, and other components were appropriately added thereto as subcomponents (for example, see Patent Document 1).

The above zinc oxide-based transparent conductive film is superior from an industrial point of view since its raw material price is lower than that in the case in which indium oxide is used; however, the zinc oxide-based transparent conductive film is slightly inferior to the ITO thin film in terms of electrical conductivity. In addition, the zinc oxide-based thin film has problems in that the resistivity becomes unstable, for example, by crystalline defects generated in thin film formation, and the durability against humidification, heating, acid or alkaline is inferior to the ITO thin film. Furthermore, the Clarke number of zinc is as low as 0.004, and zinc is also a rare metal.

Although the zinc oxide-based thin film is superior to the ITO thin film in terms of cost as described above, the situation in which a rare metal is used is still not changed, and in addition, the electrical conductivity and the durability are still required to be improved.

Patent Document 1: Japanese Unexamined Patent Application Publication No. 2006-200016

Disclosure of Invention

Problems to be Solved by the Invention

As described above, attention has been increasingly paid to the ITO alternative material. Although, many ZnO-based transparent conductive films each used as the ITO alternative material were reported, they were still required to be improved as the ITO alternative material.

Accordingly, an object of the present invention is to provide a novel transparent conductive film which is neither the ITO thin film nor the ZnO-based transparent conductive film and a method for manufacturing the novel transparent conductive film.

Means for Solving the Problems

Through intensive research carried out by the inventors of the present invention in consideration of the above object, a novel transparent conductive film and a method for manufacturing the same were discovered, and as a result, the present invention was made.

That is, a transparent conductive film of the present invention contains magnesium, at least one element (A) selected from the group consisting of carbon, silicon and boron, oxygen, and hydrogen.

As the transparent conductive film of the present invention, a transparent conductive film containing magnesium, carbon, oxygen, and hydrogen is preferable. The atomic ratio (magnesium/carbon) between magnesium and carbon contained in this transparent conductive film is preferably 0.3 to 20.

A crystalline structure of the transparent conductive film preferably has a brucite structure.

The transparent conductive film of the present invention is obtained by forming a film containing magnesium and an element (A) on a substrate and holding the film in an atmosphere containing water, which forming uses a target containing magnesium and a target containing the element (A) being at least one selected from the group consisting of carbon, silicon and boron.

The transparent conductive film of the present invention is preferably obtained by forming a film containing magnesium and carbon on a substrate and holding the film in an atmosphere containing water, which forming uses a target containing magnesium and a target containing carbon.

The above atmosphere containing water is preferably the air containing water vapor or an underwater environment.

The film formation is preferably performed by a co-sputtering method.

A method for manufacturing a transparent conductive film of the present invention comprises forming a film containing magnesium and an element (A) on a substrate and holding the film in an atmosphere containing water, which forming uses a target containing magnesium and a target containing the element (A) being at least one selected from the group consisting of carbon, silicon and boron.

A method for manufacturing a transparent conductive film of the present invention comprises forming a film containing magnesium and carbon on a substrate and holding the film in an atmosphere containing water, which forming uses a target containing magnesium and a target containing carbon.

In addition, a transparent conductive film of the present invention is obtained by forming a film containing magnesium and an element (A) on a substrate and holding the film in an atmosphere containing water, which forming uses an evaporation source containing magnesium and an evaporation source containing the element (A) being at least one selected from the group consisting of carbon, silicon and boron.

In addition, a method for manufacturing a transparent conductive film of the present invention comprises forming a film containing magnesium and an element (A) on a substrate and holding the film in an atmosphere containing water, which forming uses an evaporation source containing magnesium and an evaporation source containing the- element (A) being at least one selected from the group consisting of carbon, silicon and boron.

Advantages

The transparent conductive film of the present invention has superior visible light transmission property and electrical conductivity. In addition, the Clarke number of magnesium contained in the transparent conductive film of the present invention is 1.98, and hence no resource depletion problem occurs.

Brief Description of Drawings

[Fig. 1] Fig. 1 includes views each showing the change with time when a MgC film obtained in Example 1 is held in the atmosphere, (a-1) immediately after film formation, (a-2) 5 minutes after the film formation, (a-3) 10 minutes after the film formation, and (a-4) 15 minutes after the film formation.

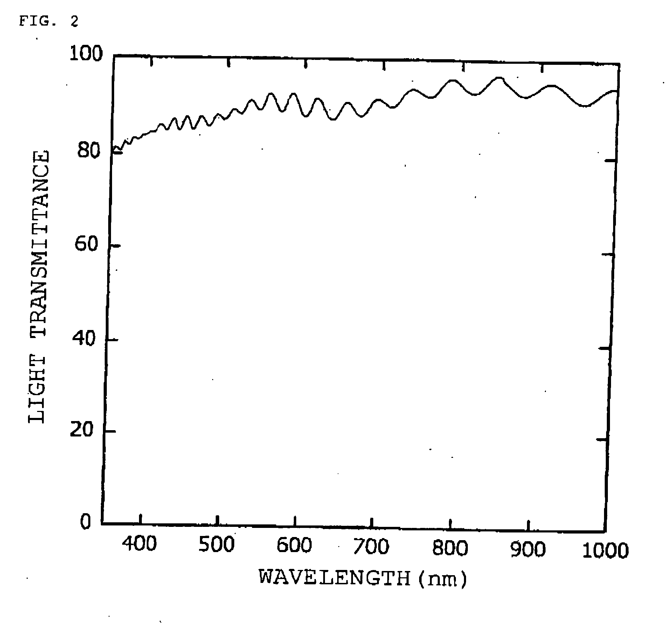

[Fig. 2] Fig. 2 is a view showing the light transmittance of a transparent conductive film obtained in Example 1.

[Fig. 3] Fig. 3 shows an x-ray diffraction result of the transparent conductive film obtained in Example 1.

[Fig. 4] Fig. 4 is a view showing a composition of the transparent conductive film obtained in Example 1, where at% on the vertical axis indicates the atomic ratio (atomic percent).

[Fig. 5] Fig. 5 is a view showing smoothness (arithmetic average roughness (Ra): 43 nm) of the transparent conductive film obtained in Example 1.

[Fig. 6] Fig. 6 includes views each showing a surface shape of the transparent conductive film obtained in Example 1.

[Fig. 7] Fig. 7 is a view showing a specific resistance value of the transparent conductive film obtained in Example 1.

Best Modes for Carrying Out the Invention

Hereinafter, the present invention will be described in detail.

[Transparent conductive film]

A transparent conductive film of the present invention contains magnesium, at least one element (A) selected from the group consisting of carbon, silicon and boron, oxygen, and hydrogen.

As the element (A), in view of the electrical conductivity of the transparent conductive film, at least carbon is preferably contained.

In addition, the atomic ratio of magnesium to the element (A) (magnesium/element (A)) of the transparent conductive film of the present invention is generally 0.3 to 20, preferably 0.5 to 10, and more preferably 1 to 5. When the atomic ratio is in the range described above, the light transmission property and the electrical conductivity of the transparent conductive film are improved.

When the element (A) is carbon, the atomic ratio of magnesium to carbon (magnesium/carbon) is generally 0.3 to 20, preferably 0.5 to 10, and more preferably 1 to 5. When the atomic ratio is in the range described above, the light transmission property and the electrical conductivity of the transparent conductive film are improved.

In addition, the atomic ratio of magnesium to oxygen (magnesium/oxygen) is generally 0.48 to 0.53 and preferably 0.49 to 0.52.

. In addition, the atomic ratio of oxygen to hydrogen (oxygen/hydrogen) is generally 0.5 to 1.5 and preferably 0.9 to 1.1.

The transparent conductive film of the present invention may contain another element as long as the light transmission property and the electrical conductivity are not adversely influenced. As the another element, for example, nitrogen may be mentioned.

<Structure of transparent conductive film>

In the transparent conductive film of the present invention, it is preferable that magnesium, the element (A), oxygen, and hydrogen be uniformly distributed in the entire transparent conductive film. When the elements are uniformly distributed as described above, the variation in characteristics, such as the light transmission property and the electrical conductivity, of the entire transparent conductive film is decreased.

In addition, the above "uniformly distributed" indicates that each component is distributed without being segregated.

The thickness of the transparent conductive film of the present invention is generally 0.1 to 5.0 $\mu$m and preferably 1.0 to 3.5 $\mu$m. When the thickness is in the range described above, a transparent conductive film having high light transmission property and electrical conductivity can be obtained. In addition, the thickness is an average thickness of 2 points measured by an AFM (atomic force microscope) and a SEM (scanning electron microscope).

In view of the visible light transmission property and the electrical conductivity, the crystalline structure of the transparent conductive film of the present invention preferably has a structure having the symmetry of $Mg(OH)_2$, that is, a brucite structure. The structure can be confirmed by analyzing a diffraction angle of an x-ray diffraction peak. In addition, although conventionally known transparent conductive films are all oxides, the transparent conductive film in which the crystalline structure thereof has a brucite structure has been confirmed to be a non-oxide-based transparent conductive film from the structure thereof.

In addition, in the crystalline structure of the transparent conductive film of the present invention, although the state in which the element (A) is present was not clearly understood, when x-ray diffraction peaks of $Mg(OH)_2$ were compared with those of the transparent conductive film of the present invention, the (001) peak of the transparent conductive film of the present invention was shifted to a low angle side as compared to the (001) peak of $Mg(OH)_2$, that is, the interlayer distance of the brucite structure was increased; hence, the inventors of the present invention estimated that the element (A) was present between layers of the brucite structure. The inventors of the present invention estimated that since having the crystalline structure as described above, the transparent conductive film of the present invention had superior electrical conductivity.

Since primary elements forming the non-oxide-based transparent conductive film having a brucite structure are all light elements as described above, and in addition, since the Clarke numbers thereof are high, the non-oxide-based transparent conductive film is superior to a conventional oxide-based transparent conductive film from economical and resource points of view. In addition, since the non-oxide-based transparent conductive film has a structure having the symmetry of $Mg(OH)_2$ (brucite structure), it is believed that when the transparent conductive film is heated in a reducing atmosphere (such as a hydrogen atmosphere), the brucite structure is decomposed into a hydride of magnesium, water vapor, and a hydrocarbon. The hydride of magnesium is easily converted into a magnesium element by heating to 400°C in a vacuum atmosphere at approximately $1 \times 10^{-2}$ Pa. That is, from the non-oxide-based transparent conductive film, a magnesium element can be easily obtained, and the non-oxide-based transparent conductive film is superior from a resource point of view.

<Light transmittance>

The transparent conductive film of the present invention generally has a light transmittance of 80% or more in a wavelength range of 350 to 2,500 nm. In particular, in a visible light wavelength region (380 to 780 nm), the transmittance is preferably 80% or more. In addition, in this specification, the light transmittance is measured in accordance with a measurement method defined by the transmittance test method for a fine ceramic thin film (JIS R 1635).

<Specific resistance of transparent conductive film>

A lower specific resistance of the transparent conductive film of the present invention is more preferable, and it is generally $5 \times 10^{-1}$ $\Omega \cdot$cm or less. The specific resistance is measured by a four-probe method defined by the specific resistance test method for a fine ceramic thin film (JIS R 1637).

<Crystal grains of transparent conductive film>

Crystal grains forming the transparent conductive film of the present invention can be observed using a scanning electron microscope. The average grain diameter thus observed is preferably 30 to 500 nm, more preferably 30 to 350 nm, and even more preferably 100 to 200 nm. When the average grain diameter is in the range described above, the smoothness of the transparent conductive film is improved, diffuse reflection in the visible light region is suppressed, and the transparency of the transparent conductive film is improved. The average grain diameter described above is an average grain diameter based on the biaxial average diameter of each crystal grain observed using a scanning electron microscope.

[Method for manufacturing transparent conductive film]

A method for manufacturing a transparent conductive film of the present invention is not particularly limited, and for example, by using a PVD (physical vapor deposition) method, manufacturing can be performed by the following method.

As the PVD (physical vapor deposition) method, for example, there may be mentioned a method categorized into a sputtering system and a method categorized into an evaporation system, such as a vacuum deposition method, an ion beam deposition method, or an MBE (molecular beam epitaxial) method. The method categorized into a sputtering system is preferable since high vacuum is not required as compared to the method categorized into an evaporation system, and a high melting point material, such as carbon, can be easily formed into a film.

A method (1) for manufacturing a transparent conductive film using the method categorized into a sputtering system comprises forming a film containing magnesium and an element (A) on a substrate and holding the film in an atmosphere containing water, which forming uses a target containing magnesium and a target containing the element (A) being at least one selected from the group consisting of carbon, silicon and boron.

A method (2) for manufacturing a transparent conductive film using the method categorized into an evaporation system comprises forming a film containing magnesium and an element (A) on a substrate and holding the film in an atmosphere containing water, which forming uses an evaporation source containing magnesium and an evaporation source containing the element (A) being at least one selected from the group consisting of carbon, silicon and boron.

[Method (1) for manufacturing transparent conductive film]

A first method for manufacturing a transparent conductive film of the present invention comprises forming a film containing magnesium and an element (A) on a substrate and holding the film in an atmosphere containing water, which forming uses a target containing magnesium and a target containing the element (A) being at least one selected from the group consisting of carbon, silicon and boron.

That is, the transparent conductive film of the present invention can be obtained by forming a film containing magnesium and an element (A) on a substrate and holding the film in an atmosphere containing water, which forming uses a target containing magnesium and a target containing the element (A) being at least one selected from the group consisting of carbon, silicon and boron.

<Target containing magnesium>

In the target containing magnesium used for forming the transparent conductive film of the present invention, the purity of magnesium is generally 2N5 (99.5 percent by weight) or more and preferably 3N (99.9 percent by weight) or more.

The target containing magnesium may contain another element as long as the light transmission property and the electrical conductivity of the transparent conductive film formed from this target are not adversely influenced.

In addition, as the target containing magnesium, a commercially available product, such as a magnesium target for sputtering, may also be used.

<Target containing at least one element (A) selected from the group consisting of carbon, silicon and boron>

In the target containing the element (A) used for forming the transparent conductive film of the present invention, the purity of the element (A) is generally 2N5 (99.5 percent by weight) or more and preferably 3N (99.9 percent by weight) or more. As a composition component of the target, another element may also be contained as long as the light transmission property and the electrical conductivity of the transparent conductive film formed from this target are not adversely influenced.

In addition, as the target containing the element (A), a commercially available product, such as a sputtering target, may also be used.

As the target containing the element (A), a target containing carbon is preferable in view of the electrical conductivity. As the target containing carbon, carbon graphite is more preferable in view of the electrical conductivity.

Although depending on the atomic ratio between magnesium and the element (A) contained in a transparent conductive film to be manufactured, the weight ratio between the target containing magnesium and the target containing the element (A) (target containing magnesium/target containing the element (A)), which are used for the method for manufacturing a transparent conductive film of the present invention, is generally 0.6 to 40, preferably 1 to 20, and more preferably 2 to 10. In the range described above, the composition of a transparent conductive film to be obtained can be set in a preferable range, and a transparent conductive film having superior visible light transmission property and electrical conductivity can be manufactured.

Although depending on the atomic ratio between magnesium and the element (A) contained in a transparent conductive film to be manufactured, the surface area ratio between the target containing magnesium and the target containing the element (A) (target containing magnesium/target containing the element (A)), which are used for the method for manufacturing a transparent conductive film of the present invention, is generally 1.47 to 48.7 and preferably 2.40 to 33.6. In the range described above, the composition of a transparent conductive film to be obtained can be set in a preferable range, and a transparent conductive film having superior visible light transmission property and electrical conductivity can be manufactured.

In addition, a mosaic target may also be used in which the targets each containing magnesium and the targets each containing the element (A) are arranged in a mosaic pattern.

<Film formation>

In the method for manufacturing a transparent conductive film of the present invention, a film containing magnesium and the element (A) is formed on a substrate by using the target containing magnesium and the target containing the element (A).

As the film forming method, for example, a method in which film formations are simultaneously performed on a substrate by using at least two targets containing different components and a method in which film formations are alternately performed on a substrate by using at least two targets containing different components may be mentioned. When a transparent conductive film is manufactured, since the composition thereof is easily controlled, a co-sputtering method is preferably used in which film formations are simultaneously performed on a substrate by using at least two targets containing different components.

(Co-sputtering method)

When the co-sputtering method is used, a sputtering apparatus is not particularly limited, and a commercially available apparatus, such as SPC-350 (manufactured by Anelva Corporation), may be used.

A sputtering gas used for a co-sputtering method is not particularly limited, and an inert gas, such as argon, neon, or xenon, may be mentioned. In view of sputtering rate and cost, argon is preferably used.

In addition, although a sputtering electrical power depends on the atomic ratio between magnesium and the element (A) in a transparent conductive film to be manufactured, an electrical power to the target containing magnesium is generally 40 to 200 W and preferably 100 to 160 W, and an electrical power to the target containing the element (A) is generally 100 to 500 W and preferably 300 to 400 W. When the sputtering electrical power is in the range described above, the atomic ratio between magnesium and the element (A) in a transparent conductive film to be obtained can be set in the above preferable range.

In view of the light transmission property and the electrical conductivity of a desired transparent conductive film, the thickness of the film containing magnesium and the element (A) obtained by the film formation is generally 0.1 to 5.0 $\mu$m and preferably 1.0 to 3.5 $\mu$m. In addition, the thickness is an average thickness of 2 points measured by an AFM (atomic force microscope) and a SEM (scanning electron microscope).

In addition, although depending on the thickness of the film containing magnesium and the element (A), a film formation time is generally 2 minutes to 12 hours and preferably 3 minutes to 5 hours.

(Substrate)

A substrate used for the first method for manufacturing a transparent conductive film of the present invention is not particularly limited, and for example, a glass substrate, a polymer substrate, or the like may be used in accordance with the application of the transparent conductive film. For example, a glass substrate is preferably used for a liquid crystal display panel, and a polymer substrate is preferably used for a transparent touch panel.

In addition, before the film formation is performed, the substrate is preferably cleaned. As a cleaning liquid, for example, an organic solvent, such as ethanol, for a glass substrate, and an acid or an alkaline solution for a polymer substrate may be used. In addition, as a cleaning method, for example, ultrasonic cleaning may be mentioned.

(Atmosphere containing water)

In the first method for manufacturing a transparent conductive film of the present invention, when the film containing magnesium and the element (A) obtained as described above is held in an atmosphere containing water, a transparent conductive film can be obtained. A holding time is primarily determined by an atmosphere containing water.

As the above atmosphere containing water, for example, the air containing water vapor and an underwater environment may be mentioned.

(Air containing water vapor)

In the air containing water vapor, the relative humidity is generally 30 to 100 percent by weight and preferably 40 to 100 percent by weight. When a film containing magnesium and the element (A) is held in the air containing water vapor, a higher relative humidity is more preferable since a transparent conductive film can be rapidly obtained. However, in order to hold the film under a high humidity condition, a high humidity bath must be additionally provided, and from an industrial point of view, in consideration of a desired production rate, cost, and the like in combination, the relative humidity can be appropriately determined.

In the case in which a film containing magnesium and the element (A) is held in the air containing water vapor, in general, when the film is held for 10 minutes or more, a transparent conductive film having a light transmission property and an electrical conductivity can be obtained. In addition, in general, the holding time can be decreased as the thickness of the film containing magnesium and the element (A) is smaller and as the relative humidity is higher. For example, when a film (thickness: 2.5 $\mu$m) containing magnesium and carbon formed on a glass substrate is held in the air containing water vapor at a relative humidity of 60 percent by weight, the holding time is generally 10 to 30 minutes.

(Underwater environment)

As the water described above, although tap water and purified water may both be used, tap water is preferably used in view of the cost, and purified water is preferably used in view of the quality of a film to be obtained.

When a film containing magnesium and the element (A) is held in water, the temperature thereof is generally 10°C to 60°C and preferably 20°C to 30°C.

When a film containing magnesium and the element (A) is held in water, by holding the film for generally 10 minutes or more and preferably 10 to 30 minutes, a transparent conductive film having a light transmission property and an electrical conductivity can be obtained.

[Method (2) for manufacturing transparent conductive film]

The second method for manufacturing a transparent conductive film of the present invention comprises forming a film containing magnesium and an element (A) on a substrate and holding the film in an atmosphere containing water, which forming uses an evaporation source containing magnesium and an evaporation source containing the element (A) being at least one selected from the group consisting of carbon, silicon and boron.

That is, the transparent conductive film of the present invention can be obtained by forming a film containing magnesium and an element (A) on a substrate and holding the film in an atmosphere containing water, which forming uses an evaporation source containing magnesium and an evaporation source containing the element (A) being at least one selected from the group consisting of carbon, silicon and boron.

<Evaporation source containing magnesium>

In the evaporation source containing magnesium used for forming the transparent conductive film of the present invention, the purity of magnesium is generally 2N5 (99.5 percent by weight) or more and preferably 3N (99.9 percent by weight) or more.

The evaporation source containing magnesium may contain another element as long as the light transmission property and the electrical conductivity of the transparent conductive film formed from this evaporation source are not adversely influenced.

In addition, as the evaporation source containing magnesium, a commercially available product, such as deposition-purpose magnesium block, powder, flakes, or pellets, may also be used.

<Evaporation source containing at least one element (A) selected from the group consisting of carbon, silicon and boron>

In the evaporation source containing the element (A) used for forming the transparent conductive film of the present invention, the purity of the element (A) is generally 2N5 (99.5 percent by weight) or more and preferably 3N (99.9 percent by weight) or more. As a composition component of the evaporation source, another element may also be contained as long as the light transmission property and the electrical conductivity of the transparent conductive film formed from this evaporation source are not adversely influenced.

In addition, as the evaporation source containing the element (A), a commercially available product, such as deposition-purpose block, powder, flakes, or pellets, may also be used.

As the evaporation source containing the element (A), an evaporation source containing carbon is preferable in view of the electrical conductivity. As the evaporation source containing carbon, carbon graphite is more preferable in view of the electrical conductivity.

<Film formation>

In the second method for manufacturing a transparent conductive film of the present invention, a film containing magnesium and the element (A) is formed on a substrate by using the evaporation source containing magnesium and the evaporation source containing the element (A).

As the film forming method, for example, a vacuum deposition method, an ion beam deposition method, or an MBE (molecular beam epitaxial) method may be mentioned. Among those mentioned above, since the composition of the transparent conductive film is easily controlled, an MBE (molecular beam epitaxial) method is preferably used.

(Substrate)

As a substrate used for the second method for manufacturing a transparent conductive film of the present invention, a substrate similar to that described in the first manufacturing method may be used.

(Atmosphere containing water)

In the second manufacturing method of the present invention, when the film containing magnesium and the element (A) obtained as described above is held in an atmosphere containing water which is similar to that of the above first manufacturing method, a transparent conductive film can be obtained.

[Application of transparent conductive film]

The transparent conductive film of the present invention has a light transmission property and an electrical conductivity and can be used as an alternative material of an ITO thin film which suffers from a more serious resource depletion problem.

For example, when a transparent conductive film is formed on a glass substrate, the film thus formed can be used as a surface electrode of a solar cell or a drive electrode of a liquid crystal display. In addition, when a transparent conductive film is formed on a resin film, the film thus formed can be used as a transparent electrical conductive film for an electrode of a transparent touch panel or an EL (electroluminescence) flat lamp.

Examples

Hereinafter, the present invention will be described in more detail with reference to Examples; however, the present invention is not limited thereto.

[Example 1]

(Preparation before film formation)

A glass substrate (Pyrex (registered trademark) glass having a thickness of 0.7 mm, manufactured by Dow Corning Co., Ltd.) processed by ultrasonic cleaning in ethanol was fitted to a rotary substrate holder (revolution rate: 60 rpm) (anode side) and was disposed in a sputtering chamber in parallel to a sputtering target surface.
As a sputtering target, magnesium (magnesium target having a purity of 3N (99.9 percent by weight), manufactured by Kojundo Chemical Laboratory Co., Ltd.) and carbon graphite (carbon target having a purity of 3N (99.9 percent by weight), manufactured by Nilaco Corporation) were disposed at a cathode side.
As a sputtering apparatus, SPC-350 (manufactured by Anelva Corporation) was used.

(Film formation treatment)

The inside of the sputtering chamber was evacuated to a pressure of $2.8 \times 10^{-3}$ Pa by a vacuum pump.
Next, an argon gas (purity: 6N (99.9999 percent by weight) or more, manufactured by Japan Fine Products Co., Ltd.) was introduced into the chamber as a sputtering gas so as to maintain a total pressure of 0.5 Pa. An argon gas flow rate in this step was set to 5.0 sccm.
A pre-sputtering treatment of the sputtering target by plasma discharge using argon was performed as described below. For the magnesium target, a pre-sputtering treatment was sequentially performed at 100 W for 10 minutes, 200 W for 10 minutes, and 100 W for 10 minutes in that order. For the carbon graphite target, a pre-sputtering treatment was sequentially performed at 100 W for 10 minutes, 200 W for 10 minutes, 300 W for 5 minutes, and 400 W for 5 minutes in that order.
After the pre-sputtering was performed, magnesium and carbon graphite was processed by a co-sputtering method under sputtering conditions shown in Table 1, so that a film (MgC film) containing magnesium and carbon which had an average thickness of 2.5 $\mu$m obtained from 2 points measured by an AFM (atomic force microscope) and a SEM (scanning electron microscope), which will be described later, was formed on the glass substrate.
[Table 1]

| Table 1 Sputtering conditions | |
|---|---|
| Substrate temperature at start of film formation (K) | 299 |
| Substrate temperature at end of film formation (K) | 308 |
| Revolution rate of substrate (rpm) | 60 |
| Sputtering target | Mg and C |
| Flow rate of argon gas (sccm) | 5.0 |
| Sputtering pressure (Pa) | 0.5 |
| Distance between sputtering target and substrate (mm) | 35 |
| Sputtering electrical power (W) magnesium | 100 |
| carbon | 400 |
| Film formation time (hour) | 1 |
| Film thickness ($\mu$m) | 2.5 |

(Treatment after film formation)

After the film formation treatment was performed, the sputtering gas in the sputtering chamber was evacuated to a pressure of $5 \times 10^{-3}$ Pa by a vacuum pump.

Subsequently, the glass substrate on which the MgC film was formed was removed from the sputtering chamber and was then held for 15 minutes in the air containing water vapor at a relative humidity of 60 percent by weight, so that the glass substrate on which a transparent conductive film was formed was obtained.

(Analysis of transparent conductive film)

(1) Appearance of transparent conductive film

(1-1) Appearance of transparent conductive film (visual inspection)

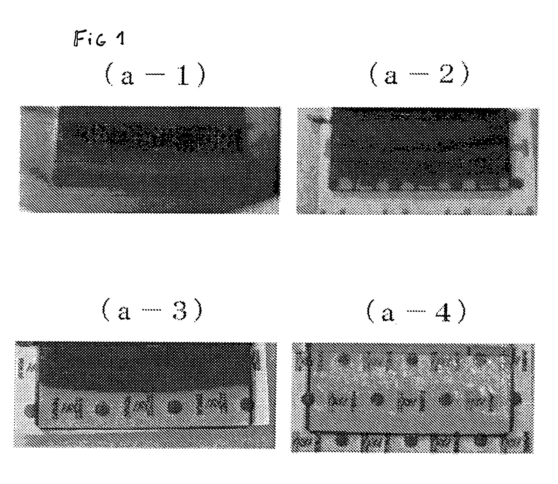

The change in appearance with time obtained when the film was held in the air containing water vapor at a relative humidity of 60 percent by weight is shown in Fig. 1.
As shown in Fig. 1 (a-1), in the state immediately after the film formation, the MgC film had a color between black (metallic gloss) and gray, and light was not allowed to transmit therethrough. However, as the holding time in the air passed ((a-1) [immediately after the film formation]→(a-2) [holding time: 5 minutes]→ (a-3) [holding time: 10 minutes]→ (a-4) [holding time: 15 minutes]), light was allowed to transmit through the MgC film, that is, the film was changed to a transparent conductive film.

(1-2) Appearance of transparent conductive film (light transmittance)

The light transmittance of the transparent conductive film in a wavelength range of 350 to 1,000 nm was measured by a UV-visible light spectrophotometer. The result is shown in Table 2. In a wavelength range of 350 to 1,000 nm, the light transmittance of the transparent conductive film was 80% or more.
In this measurement, a transmittance ($T_3$) of the transparent conductive film was measured as described below.
A light transmittance ($T_1$ [%]) of the transparent conductive film including the glass substrate was measured by a UV-visible light spectrophotometer (manufactured by JASCO Corporation). A light transmittance ($T_2$ [%]) of the glass substrate only was measured under conditions similar to those of the reference, and the transmittance ($T_3$ [%]) of the transparent conductive film was obtained from the following equation.
$$T_3 = (T_1/T_2) \times 100 \ [\%]$$

The measurement was performed in accordance with a measurement method defined by the transmittance test method for a fine ceramic thin film (JIS R 1635).

(2) Composition and structure of transparent conductive film

(2-1) X-ray diffraction measurement of transparent conductive film

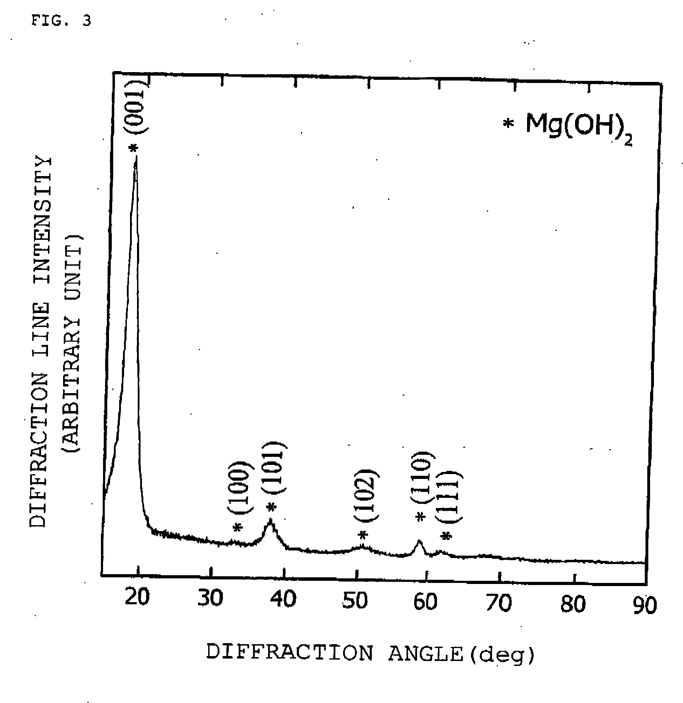

The x-ray diffraction result (x-ray diffraction apparatus for thin film-material crystalline analysis, manufactured by Japan Philips Co., Ltd.) of the transparent conductive film is shown in Fig. 3. As an incident x ray, the CuK$\alpha$ ray (40 kv, 40 mA) was used, and the incident angle was set to 1°. Since intensive peaks from the (001), (101), and (110) planes of a $Mg(OH)_2$ structure were observed, it was found that the transparent conductive film had a structure (brucite structure) having the symmetry of $Mg(OH)_2$.

(2-2) X-ray photoelectron spectroscopy of transparent conductive film

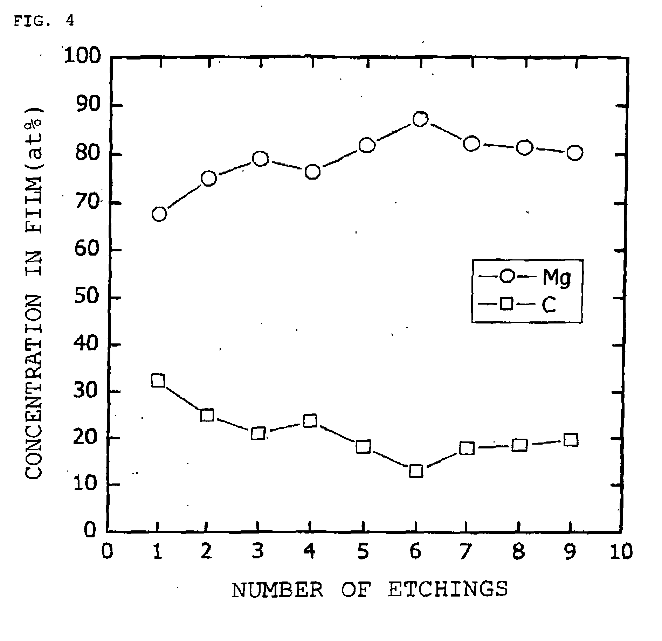

As shown in Fig. 4, while etching was performed using argon ions from the surface of the transparent conductive film in the depth direction, a composition analysis thereof was performed at each of stages by XPS (x-ray photoelectron spectroscopy, manufactured by Ulvac-Phi, Incorporated). The atomic ratio of magnesium to carbon, magnesium/carbon, in the transparent conductive film which was obtained by averaging the data of the stages was 3.8 (atomic ratio).

(2-3) Wavelength-dispersive element analysis of transparent conductive film

A WDX (wavelength-dispersive element analysis, manufactured by Shimadza Corporation) analysis of the transparent conductive film was performed, and it was observed that magnesium, carbon, and oxygen coexisted in the transparent conductive film.

In addition, since the presence of magnesium and carbon was confirmed in the above (2-2), the presence of magnesium, carbon, and oxygen was confirmed by the above (2-3), and further according to the above (2-1), the transparent conductive film had the structure (brucite structure) having the symmetry of $Mg(OH)_2$, it was estimated that in the transparent conductive film of the present invention, magnesium, carbon, oxygen, and hydrogen coexisted.

In addition, by the wavelength-dispersive element analysis and the x-ray photoelectron spectroscopy, carbon was apparently contained in the transparent conductive film, the structure of the transparent conductive film had the symmetry of $Mg(OH)_2$, and the (001) peak of the transparent conductive film was shifted to a low angle side as compared to the (001) peak of $Mg(OH)_2$, that is, the interlayer distance of the brucite structure was increased; hence, it was estimated that carbon atoms (C) were incorporated between the layers of the brucite structure.

(2-4) Observation of transparent conductive film by atomic force microscope

The transparent conductive film was observed by an AFM (atomic force microscope, manufactured by Keyence Corporation).

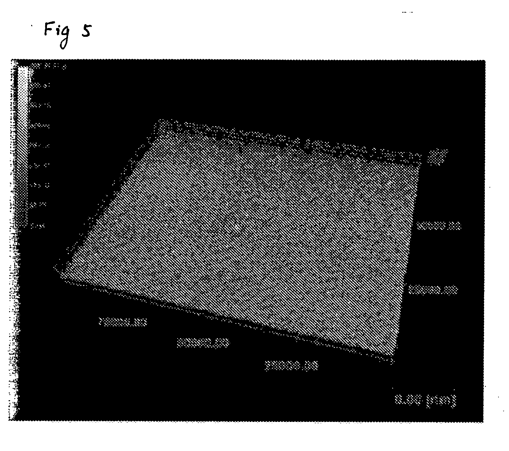

It was found from Fig. 5 that an arithmetic average roughness Ra indicating the smoothness of the transparent conductive film was 43 nm.

(2-5) Observation of transparent conductive film by scanning electron microscope

The transparent conductive film was observed by a SEM (scanning electron microscope, manufactured by Hitachi Ltd.).

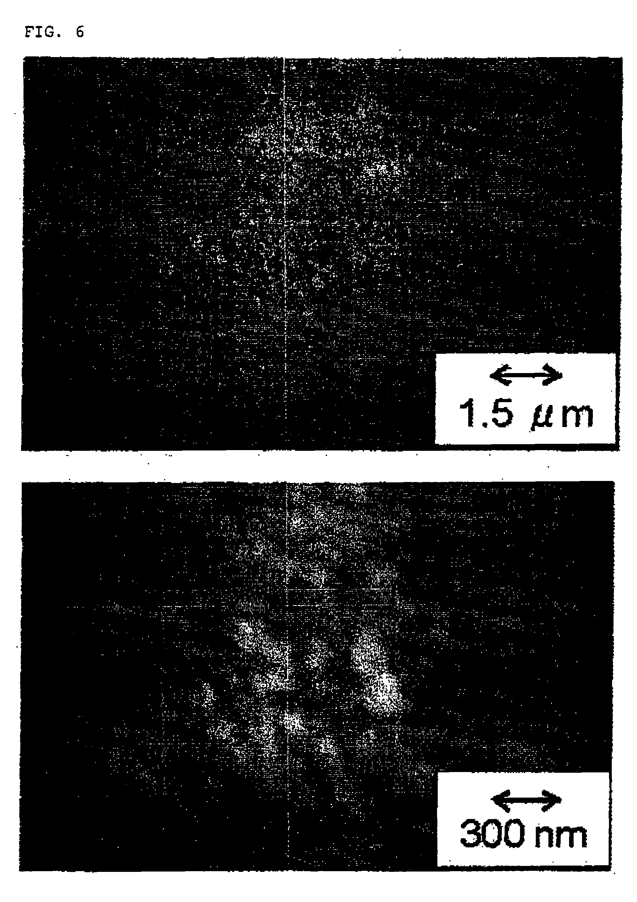

It was found from Fig. 6 that the average grain diameter of crystalline grains of the transparent conductive film based on the biaxial average diameter was 150 nm.

(2-6) Measurement of specific resistance of transparent conductive film

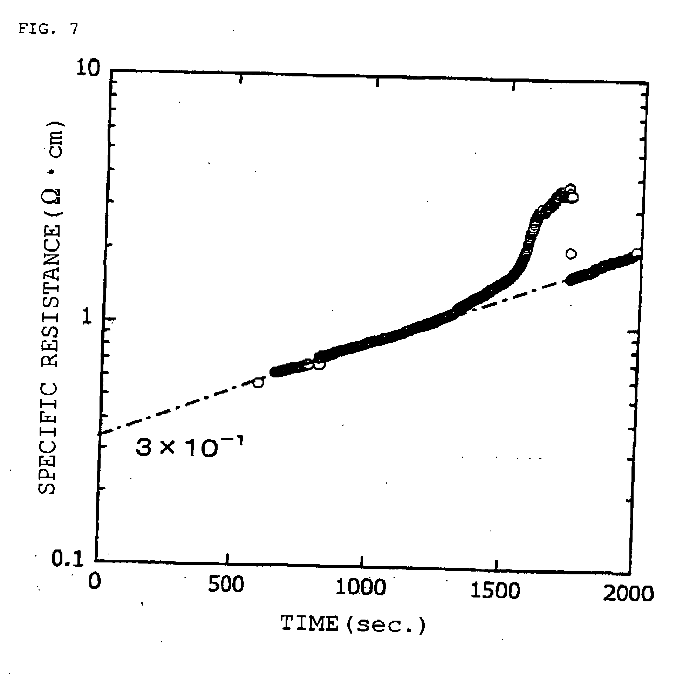

A specific resistance value of the transparent conductive film was calculated from a surface resistance measured by a four-probe method (apparatus name: HiTESTER, manufactured by Hioki E. E. Corporation). As a result, as shown in Fig. 7, the specific resistance value of the transparent conductive film was $3\times10^{-1}$ $\Omega$·cm which was obtained by extrapolation.

The specific resistance was measured by a four-probe method defined by the specific resistance test method for a fine ceramic thin film (JIS R 1637).

This specific resistance was approximately equivalent to the value of an ITO thin film or a ZnO thin film, which was developed at the early stage.

[Example 2]

After film formation was performed, a procedure similar to that of Example 1 was performed except that a glass substrate on which a MgC film was formed was held in a distilled water (temperature: 23°C, and immersion time: 30 minutes) instead of holding it in the air, and the glass substrate on which a transparent conductive film was formed was obtained.

[Comparative Example 1]

A film formation treatment and preceding steps were performed in a manner similar to those of Example 1.

After the film formation was performed, a sputtering gas in a sputtering chamber was evacuated to a pressure of $5.0\times10^{-3}$ Pa by a vacuum pump.

Subsequently, after the evacuation was completed, a dry nitrogen gas (purity: 5N5 (99.9995 percent by weight) or more, manufactured by Nippon Sanso Corporation) was introduced into the sputtering chamber in an airtight state, so that the total pressure was maintained at 40 kPa.

Next, a glass substrate on which a MgC film was formed was held in the chamber for 48 hours in a dry nitrogen gas atmosphere and was observed with time. However, the MgC film had a color between black (metallic gloss) and gray and was not changed to be transparent.

[Comparative Example 2]

After a film formation treatment was performed, a process was performed in a manner similar to that in Comparative Example 1 except that a dry oxygen gas (purity: 6N5 (99.99995%) or more, manufactured by Japan Fine Products Co., Ltd.) was introduced in a chamber instead of a nitrogen gas.

As a result, the MgC film had a color between black (metallic gloss) and gray and was not changed to be transparent.

[Comparative Example 3]

After a film formation treatment was performed, a process was performed in a manner similar to that in Comparative Example 1 except that dry air (manufactured by Japan Fine Products Co., Ltd.) was introduced in a chamber instead of a nitrogen gas.

As a result, the MgC film had a color between black (metallic gloss) and gray and was not changed to be transparent.

[Examples 3 to 5]

After the treatment of each of Comparative Examples 1 to 3 was performed, when the glass substrate on which the MgC film was formed was held in the air under conditions similar to those of Example 1, the glass substrate on which a transparent conductive film was formed was obtained.

When the MgC film was held in the air containing water vapor in Examples 1 and 3 to 5, and when the MgC film was held in distilled, water in Example 2, light was allowed to transmit through the MgC film, that is, the MgC film was changed to a transparent conductive film. In addition, since no transparent conductive film could be obtained in the atmosphere of each of Comparative Examples, it was found that when the transparent conductive film of the present invention is manufactured, the holding of the MgC film in an atmosphere containing water is effective.

Industrial Applicability

The transparent conductive film of the present invention can be used as an ITO alternative material since the transparency and the electrical conductivity thereof are superior and no rare metals are used as raw materials.

**Claims**

1. A transparent conductive film containing magnesium, at least one element (A) selected from the group consisting of carbon, silicon and boron, oxygen, and hydrogen.

2. A transparent conductive film containing magnesium, carbon, oxygen, and hydrogen.

3. The transparent conductive film according to Claim 2, wherein an atomic ratio of magnesium to carbon (magnesium/carbon) is 0.3 to 20.

4. The transparent conductive film according to one of Claims 1 to 3, wherein a crystalline structure of the transparent conductive film has a brucite structure.

5. A transparent conductive film obtained by forming a film containing magnesium and an element (A) on a substrate and holding the film in an atmosphere containing water, which forming uses a target containing magnesium and a target containing the element (A) being at least one selected from the group consisting of carbon, silicon and boron.

6. A transparent conductive film obtained by forming a film containing magnesium and carbon on a substrate and holding the film in an atmosphere containing water, which forming uses a target containing magnesium and a target containing carbon.

7. The transparent conductive film according to Claim 5 or 6, wherein the atmosphere containing water is the air containing water vapor' or an underwater environment.

8. The transparent conductive film according to Claim 5 or 6, wherein the film formation is performed by a co-sputtering method.

9. A method for manufacturing a transparent conductive film comprising: forming a film containing magnesium and an element (A) on a substrate and holding the film in an atmosphere containing water, which forming uses a target containing magnesium and a target containing the element (A) being at least one selected from the group consisting of carbon, silicon and boron.

10. A method for manufacturing a transparent conductive film comprising: forming a film containing magnesium and carbon on a substrate and holding the film in an atmosphere containing water, which forming uses a target containing magnesium and a target containing carbon.

11. A transparent conductive film obtained by forming a film containing magnesium and an element (A) on a substrate and holding the film in an atmosphere containing water, which forming uses an evaporation source containing magnesium and an evaporation source containing the element (A) being at least one selected from the group consisting of carbon, silicon and boron.

12. A method for manufacturing a transparent conductive film comprising: forming a film containing magnesium and an element (A) on a substrate and holding the film in an atmosphere containing water, which forming uses an evaporation source containing magnesium and an evaporation source containing the element (A) being at least one selected from the group consisting of carbon, silicon and boron.

Fig 1

(a-1)

(a-2)

(a-3)

(a-4)

FIG. 2

FIG. 3

FIG. 4

Fig 5

FIG. 6

1.5 μm

300 nm

FIG. 7

## INTERNATIONAL SEARCH REPORT

International application No.

PCT/JP2008/068460

A.  CLASSIFICATION OF SUBJECT MATTER
*H01B5/14*(2006.01)i, *C23C14/08*(2006.01)i, *C23C14/34*(2006.01)i, *H01B13/00*
(2006.01)i

According to International Patent Classification (IPC) or to both national classification and IPC

B.  FIELDS SEARCHED

Minimum documentation searched (classification system followed by classification symbols)
H01B5/14, C23C14/08, C23C14/34, H01B13/00

Documentation searched other than minimum documentation to the extent that such documents are included in the fields searched
Jitsuyo Shinan Koho        1922-1996    Jitsuyo Shinan Toroku Koho    1996-2008
Kokai Jitsuyo Shinan Koho  1971-2008    Toroku Jitsuyo Shinan Koho    1994-2008

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X<br>A | JP 2004-11014 A  (Konica Minolta Holdings, Inc.),<br>15 January, 2004 (15.01.04),<br>Claims<br>(Family: none) | 1-3<br>4-12 |
| X<br>A | JP 2004-179139 A  (Sumitomo Osaka Cement Co., Ltd.),<br>24 June, 2004 (24.06.04),<br>Claims; Par. No. [0048]<br>(Family: none) | 1-2<br>3-12 |
| X<br>A | JP 3-183759 A  (Toyobo Co., Ltd.),<br>09 August, 1991 (09.08.91),<br>Claims; page 3, upper left column, lines 7 to 10; page 3, lower left column, lines 9 to 13<br>(Family: none) | 1-2<br>3-12 |

[X]  Further documents are listed in the continuation of Box C.      [ ]  See patent family annex.

*    Special categories of cited documents:
"A"  document defining the general state of the art which is not considered   to be of particular relevance
"E"  earlier application or patent but published on or after the international filing date
"L"  document which may throw doubts on priority claim(s) or which is cited to establish the publication date of another citation or other special reason (as specified)
"O"  document referring to an oral disclosure, use, exhibition or other means
"P"  document published prior to the international filing date but later than the priority date claimed

"T"  later document published after the international filing date or priority date and not in conflict with the application but cited to understand the principle or theory underlying the invention
"X"  document of particular relevance; the claimed invention cannot be considered novel or cannot be considered to involve an inventive step when the document is taken alone
"Y"  document of particular relevance; the claimed invention cannot be considered to involve an inventive step when the document is combined with one or more other such documents, such combination being obvious to a person skilled in the art
"&"  document member of the same patent family

Date of the actual completion of the international search
25 November, 2008 (25.11.08)

Date of mailing of the international search report
09 December, 2008 (09.12.08)

Name and mailing address of the ISA/
Japanese Patent Office

Facsimile No.

Authorized officer

Telephone No.

Form PCT/ISA/210 (second sheet) (April 2007)

**INTERNATIONAL SEARCH REPORT**

International application No.

PCT/JP2008/068460

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2000-353426 A  (Teijin Ltd.),<br>19 December, 2000 (19.12.00),<br>Claims<br>(Family: none) | 1-12 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2006200016 A